# EUROPEAN PATENT APPLICATION

(11) **EP 4 793 259 A1**
(43) Date of publication of application: **19.08.2026**
(21) Application number: 25191216.8
(22) Date of filing: 23.07.2025
(51) Int. Cl.: C04B 37/02, H10W 40/25, C04B 35/645, H10W 90/00

(54) **HEAT DISSIPATION SUBSTRATE FOR POWER SEMICONDUCTOR, POWER SEMICONDUCTOR MODULE INCLUDING THE SAME, POWER CONVERTOR INCLUDING THE SAME, AND MANUFACTURING METHOD THEREOF**

(30) Priority: 12.02.2025 KR 20250017976; 31.03.2025 KR 20250041716
(71) Applicant: LX Semicon Co., Ltd., Daejeon 34027 (KR)
(72) Inventor: CHO, Nam Tae, 34027 Daejeon (KR); BYUN, Sang Keun, 34027 Daejeon (KR)
(74) Representative: Ter Meer Steinmeister & Partner

(57) **Abstract**

The embodiments relate to a heat dissipation substrate for power semiconductors, a power semiconductor module comprising the same, a power convertor comprising the same, and a manufacturing method thereof. A method for manufacturing a heat dissipation substrate for a power semiconductor according to an embodiment may include preparing a first ceramic substrate, forming a bonding metal layer having a first thickness on one surface or the other surface of the first ceramic substrate by sputtering, arranging a metal plate on the first ceramic substrate on which the bonding metal layer may be formed, and performing a hot press process while the metal plate is arranged. In the hot press process step, the bonding metal layer may react with the first ceramic substrate to become an oxide bonding layer.

## Description

### BACKGROUND

### Field of the Disclosure

The embodiment relates to a heat dissipation substrate for a power semiconductor module, a power semiconductor module including the same, a power convertor including the same, and a manufacturing method thereof.

### Description of the Background

A power conversion module is a device that performs power converting (AC->DC, DC->AC), voltage transformation (step-down, step-up), power distribution, or power control, and the power conversion module is a core component that performs the function of improving energy efficiency in the process of transmitting and controlling power and controlling voltage changes to provide system stability and reliability. And the power conversion module may be referred to as a power module or power system.

The power conversion module may include various parts such as power semiconductor devices, heat sinks, base plates, molded silicon, cases and covers, and terminals.

Recently, eco-friendly cars based on electricity or hydrogen are in the spotlight instead of fossil fuel-based internal combustion engine vehicles, and numerous power semiconductor devices are used in these eco-friendly cars. Eco-friendly cars include hybrid electric vehicles (HEVs), plug-in hybrid electric vehicles (PHEVs), electric vehicles (EVs), and fuel cell electric vehicles (PCEVs).

Previously, silicon (Si) power semiconductor devices were widely used, but as Si power semiconductors reached their physical limits, research on WBG (Wide Bandgap) power semiconductors such as silicon carbide (SiC) or gallium nitride (GaN) is actively being conducted.

The WBG power semiconductor devices have a band gap energy approximately three times that of Si power semiconductor devices, resulting in high dielectric breakdown field (approximately 4 to 20 times), high thermal conductivity (approximately 3 to 13 times), and large electron saturation velocity (approximately 2 to 2.5 times). These characteristics enable operation in high temperature and high voltage environments, and have the advantage of high switching speed and low switching loss.

For example, Si-based power semiconductor modules used to perform power conversion, motor drive switching, control, etc. in conventional electric vehicles, hybrid electric vehicles, etc., were operated in a temperature environment of about 150°C. But recently, due to the demand for increased switching performance and power density, research is actively being conducted on wide band gap (WBG)-based power semiconductor devices such as SiC or GaN that may operate at a usage temperature of about 300°C or higher, for example, at about 300~700°C.

Meanwhile, heat generated from power semiconductors generates thermo-mechanical stress in each part of the power semiconductor module, and the life of the junction and power semiconductor devices may be deteriorated due to thermal fatigue at the junction. Therefore, it is very important to design the reliability of power semiconductor modules that appropriately release the heat generated from the power semiconductor devices through the heat dissipation substrate and maintain the junction temperature of the power semiconductor devices below an appropriate temperature.

Meanwhile, the heat dissipation substrate for power semiconductors has a function of transferring heat generated during the operation of power semiconductor devices to the outside, and the heat dissipation substrate also has an important function of electrically connecting power semiconductor devices.

Conventional power semiconductor heat dissipation substrates may be classified into DBC (direct bonded copper) and AMB (active metal brazing) methods depending on the bonding method. The DBC method is a method of forming an oxide film on a copper (Cu) layer and then directly bonding it to ceramic. The AMB method performs brazing by interposing a paste containing relatively low melting point metal particles between the base metal and ceramic as an intermediate material.

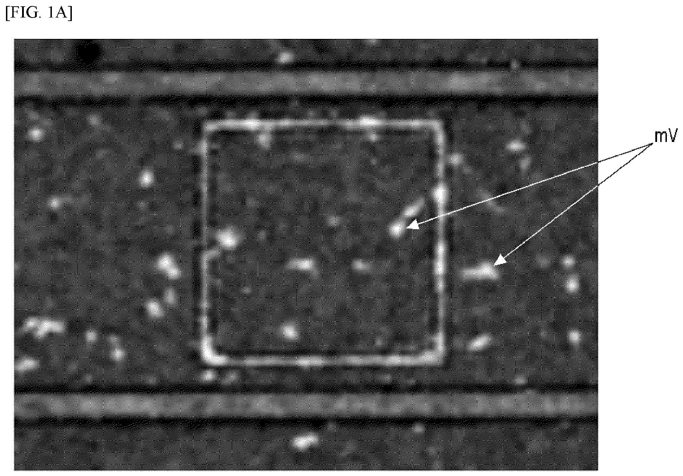

Meanwhile, FIG. 1A is a SAT (Scanning Acoustic Tomography) photograph of a first heat dissipation substrate of a conventional AMB bonding method.

In the conventional AMB technology, outgassing may occur when the flux solvent contained in the paste is vaporized during heat treatment. As a result, there is a problem in that micro voids (mV) may be generated at the bonding interface due to gas that cannot completely escape.

Accordingly, in the case of the conventional AMB technology, there is a problem that the heat dissipation characteristics are deteriorated due to micro voids that occur at the bonding interface of the heat dissipation substrate, and the bonding strength may be also deteriorated.

Meanwhile, micro voids (mV) refer to voids smaller than 1 mm in size, and in the conventional power semiconductor heat dissipation substrate industry, it was considered inevitable because it was difficult to prevent the occurrence of micro voids smaller than 1 mm.

For example, voids smaller than about 5 µm are currently excluded from void inspection, and although the void inspection standard excludes voids smaller than 5 µm, the void level is currently maintained at about 3% or less at the bonding interface.

However, recently, 1200V, 200A high-voltage/high-power SiC power conversion modules are being used for performance improvement of hybrid and electric vehicles and autonomous vehicles. During the operation of these high-performance electric vehicles, the operating temperature of power semiconductor devices is required to be implemented at an average of 300°C or higher, and these high-performance electric vehicles are facing an ultra-high temperature usage state with an instantaneous maximum operating temperature of 350°C or higher.

In such an ultra-high temperature, high voltage, and high current operating environment, the existing bonding materials themselves may be re-melted, and the heat trap phenomenon may occur due to micro voids existing in the bonding area, which may rapidly deteriorate the life of the power semiconductor module.

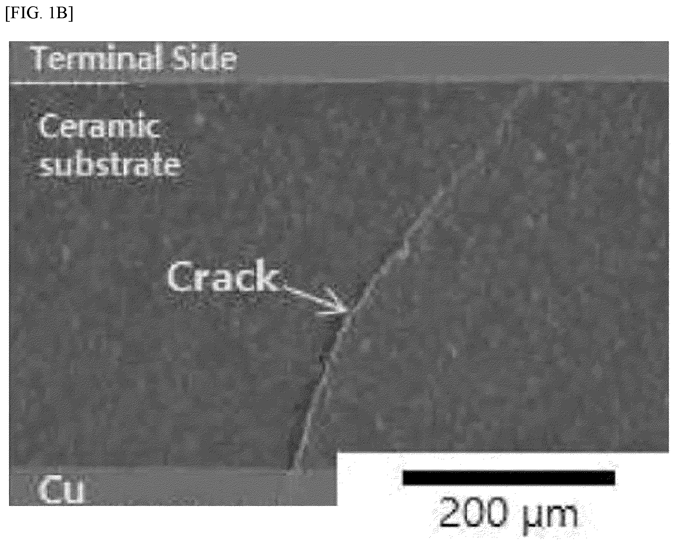

For example, FIG. 1B is an scanning electron microscope (SEM) photograph of a second heat dissipation substrate using a conventional AMB bonding method, and referring to FIG. 1B, a crack has occurred due to a defect induced at the bonding interface between the ceramic substrate of the heat dissipation substrate and the copper sheet, and the crack induced in the heat dissipation substrate may lead to the destruction of the power semiconductor device.

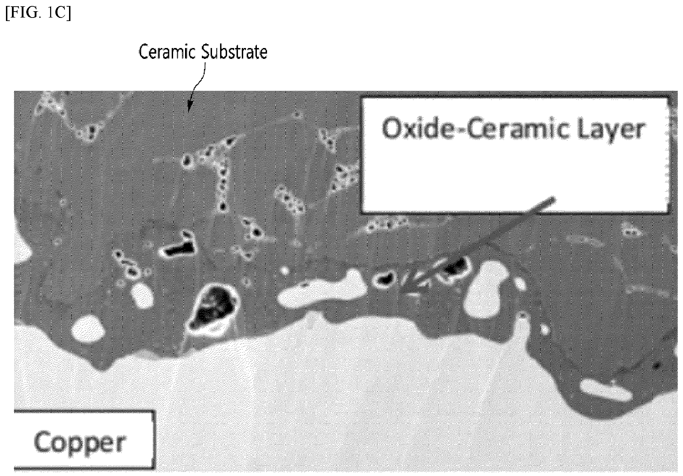

In addition, FIG. 1C is an SEM photograph of a heat dissipation substrate manufactured using a conventional DBC method, and referring to FIG. 1C, the DBC substrate requires the formation of a thick copper oxide film on a copper foil through a thermal oxidation process, and then direct heat treatment bonding may be performed on a ceramic substrate such as Al₂O₃.

However, since it is not easy to form a uniform copper oxide film for manufacturing a DBC substrate, the copper foil is not properly bonded to the ceramic substrate, and therefore micro-level voids exist at the bonding portion. Due to this, the heat dissipation substrate manufactured using the conventional DBC method is vulnerable to thermal shock, which causes rapid deterioration of the reliability or life of the power semiconductor module. In particular, in the case where the deterioration problem of the power semiconductor module occurs in an ultra-high operating temperature environment, the destruction of the power semiconductor device due to malfunction of the power semiconductor module mounted on the vehicle may have a serious impact on the safety of the driver.

Meanwhile, in the internal comparative technology, research was conducted to reduce the level of voids at the bonding interface by applying sputtering and hot press bonding technology. However, in the internal comparative technology, there was an issue of micro voids occurring at the bonding interface of the heat dissipation substrate due to the anti-oxidation layer and thick bonding metal layer (e.g., Ti, etc.), and a solution for this is needed considering the ultra-high operating temperature environment.

### SUMMARY

One of the technical objects of the present disclosure is to solve the problem of micro voids occurring at the bonding interface of the heat dissipation substrate.

Also, one of the technical objects of the present disclosure is to solve the problem of cracks occurring at the bonding interface of the heat dissipation substrate.

The technical objects of the present disclosure are not limited to those described in this item and include those that may be understood through the description of the invention. At least one of the technical objects is solved by the features of the independent claim(s).

According to an aspect of the present disclosure, a method for manufacturing a heat dissipation substrate for power semiconductors is provided, including: preparing a (first) ceramic substrate, forming a bonding metal layer of a first thickness on one side or the other side of the (first) ceramic substrate by sputtering, arranging a metal plate on the (first) ceramic substrate on which the bonding metal layer may be formed, and performing a hot press process while the metal plate is arranged.

According to a further aspect of the present disclosure, a method for manufacturing a heat dissipation substrate for a power semiconductor module is provided, including: preparing an oxide-based and/or ceramic substrate having a first side (or one side) and a second side (or the other side, i.e. opposite to the fist or one side); forming a bonding metal layer on at least one of the first and the second side of the substrate by sputtering; arranging a metal plate on the bonding metal layer; and performing a hot press process such that the bonding metal layer reacts with the substrate and/or becomes (or is converted into) an oxide bonding layer.

The method for manufacturing a heat dissipation substrate for a power semiconductor module according to any one of these aspects may include one or more of the following features:
The substrate may be a ceramic and/or oxide-based substrate.

The substrate may include or consist of Al₂O₃.

In the hot press process step, the bonding metal layer may react with the (first) oxide-based and/or ceramic substrate to become an oxide bonding layer.

The (first) substrate may include an oxide-based ceramic substrate.

The oxide bonding layer may be arranged at an interface between the (first) oxide-based and/or ceramic substrate and the metal plate. The oxide bonding layer may be arranged between the substrate and the metal plate, after the hot press process.

The metal plate may include or consist of copper.

The bonding metal layer may include Ti or TiW.

The bonding metal layer may be formed to a thickness of 0.01 to 0.03 *µ*m.

The oxide bonding layer may include titanium oxide.

The oxide bonding layer may be formed to a thickness of 0.01 to 0.03 *µ*m.

The sputtering may be performed in an inert atmosphere, e.g. under Argon gas.

The hot press process may be performed at a temperature higher than 500°C, preferably higher than 800°C, most preferably at a temperature between 900°C and 1100°C. The hot press process may be performed under vacuum conditions, e.g. at a vacuum level of 0,1 torr. In the hot press process, a pressure on the metal plate may be more than 0,5 MPa and/or less than 100 MPa, preferably more than 1 MPa, preferably between 1 MPa and 20 MPa.

According to a further aspect, a heat dissipation substrate for a power semiconductor module is provided, including: a first metal plate, a (first) oxide-based and/or ceramic substrate bonded on the first metal plate, a second metal plate bonded on the substrate, and an oxide bonding layer between the substrate and the first metal plate and/or between the substrate and the second metal plate.

The heat dissipation substrate according to this aspect may include one or more of the following features:
The heat dissipation substrate may be manufactured by a method according to any aspect or embodiment of the present disclosure.

The substrate may include or be an oxide-based and/or ceramic substrate.

The substrate may include or consist of Al₂O₃.

The first and/or second metal plate may include or consist of copper, Cu.

The oxide bonding layer may include titanium oxide.

The thickness of the oxide bonding layer may be 0.01 to 0.03 *µ*m.

According to a further aspect of the present disclosure, a power semiconductor module comprises at least one of the power semiconductor heat dissipation substrate according to any one of the aspect or embodiments described herein, at least one lead frame and at least one power semiconductor device.

According to a further aspect of the present disclosure, a power convertor includes at least one power semiconductor module according to an aspect of the present disclosure.

### TECHNICAL EFFECTS

The method for manufacturing a heat dissipation substrate for a semiconductor module, the heat dissipation substrate and the power semiconductor module having the same may include one or more of the following technical effects:
According to the power semiconductor heat dissipation substrate according to the embodiment, the power semiconductor module including the same, the power convertor including the same, and the manufacturing method thereof, there is a technical effect that can solve the problem of micro voids occurring at the bonding interface of the heat dissipation substrate.

No separate oxidation process is require for the metal plate before bonding. No anti-oxidation layer is required for bonding.

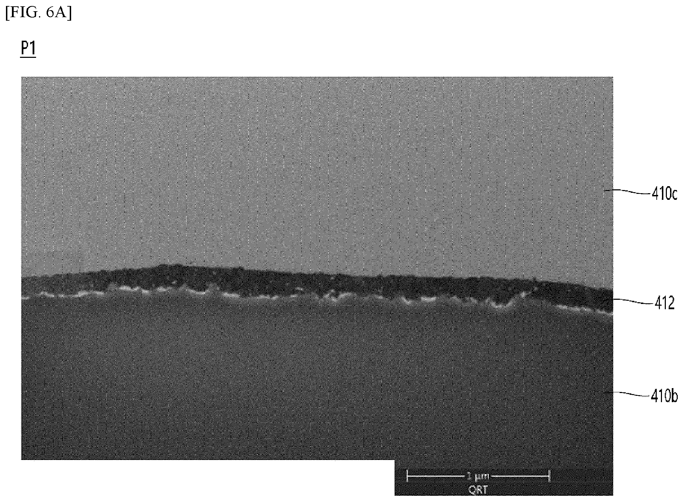

For example, referring to FIG. 6A, there is a special technical effect that no micro voids exist at the bonding interface between the oxide ceramic substrate (410b) of the first heat dissipation substrate (410) according to the embodiment and the Cu material metal plate (410c).

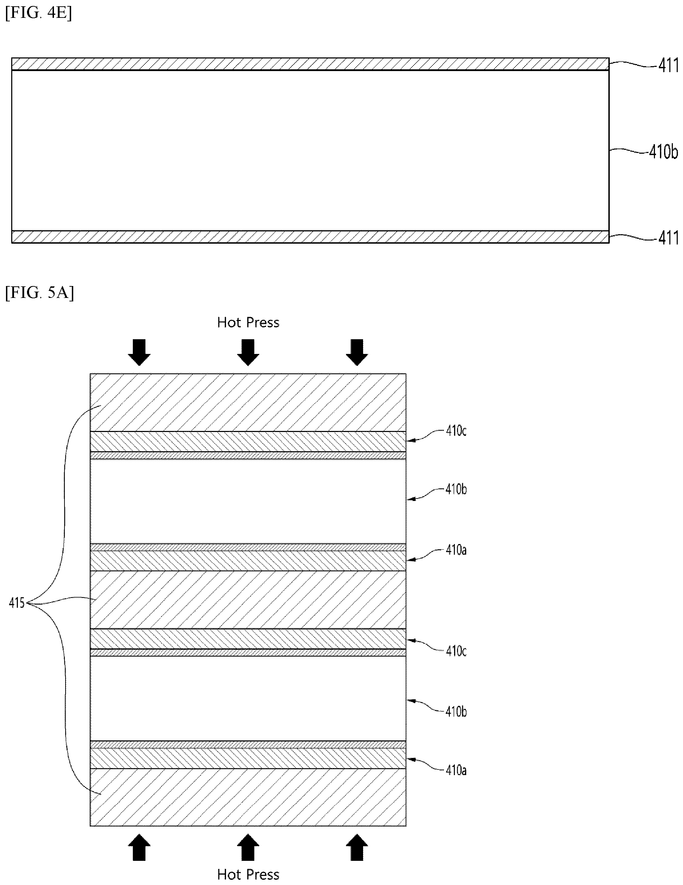

For example, in the embodiment, after forming a bonding metal layer (411) on an oxide ceramic substrate (410b) as in FIG. 4E and FIG. 5A, a high temperature and high-pressure hot press process may be performed on the metal plate (410a, 410c) made of Cu without a separate oxidation process.

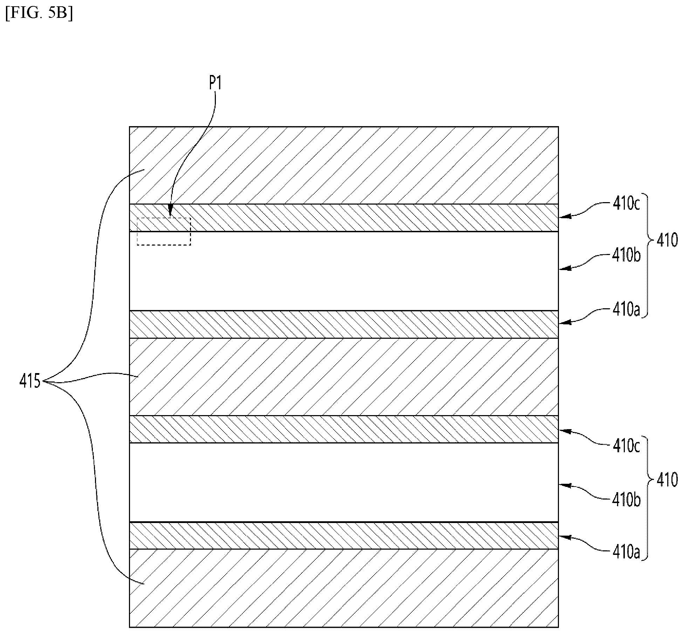

Referring to FIG. 5B and FIG. 6A together, according to the embodiment, the bonding metal layer (411) reacts with the oxide ceramic substrate (410b) to form an oxide bonding layer (412) by a hot press process of the metal plate (410a, 410c) and the oxide ceramic substrate (410b) without a separate oxidation process, and this oxide bonding layer (412) may obtain a strong bonding force between the Cu metal plate (410a, 410c) and the oxide ceramic substrate (410b).

Accordingly, according to the embodiment, since a separate oxidation process may not be performed on the metal plates (410a, 410c) before bonding, the uniformly and thinly formed bonding metal layer (411) changes into an oxide bonding layer (412), and through this, , there is a special technical effect in that a strong bonding force may be obtained without the existence of micro voids at the bonding interface between the oxide-based ceramic substrate (410b) and the Cu-based metal plate (410c).

Accordingly, according to the embodiment, there is a special technical effect of enhancing high-temperature reliability and improving high-temperature bonding strength by implementing micro void free in a power semiconductor module operating at an ultra-high temperature of 350°C or higher.

In addition, according to the embodiment, there is a technical effect of solving the problem of cracks occurring at the bonding interface of the heat dissipation substrate. For example, according to the embodiment, cracks occurring at the bonding interface between the ceramic substrate of the heat dissipation substrate and the copper sheet can be prevented from occurring, thereby improving the reliability of the power semiconductor device.

The technical effects of the embodiment may not be limited to those described in this article and may include those that may be understood through the description of the invention.

### BRIEF DESCRIPTION OF THE DRAWINGS

FIG. 1A is a SAT (Scanning Acoustic Tomography) photograph of a first heat dissipation substrate of a conventional AMB bonding method.
FIG. 1B is a SEM (Scanning Electron Microscopy) photograph of a second heat dissipation substrate of a conventional AMB bonding method.
FIG. 1C is a SEM photograph of a heat dissipation substrate manufactured by a conventional DBC method.
FIG. 2 is a circuit diagram of a power convertor (1000) to which a power semiconductor module according to an embodiment is applied.
FIG. 3A is a cross-sectional view of a power semiconductor module (500) including a heat dissipation substrate for power semiconductors according to an embodiment.
[IG. 3B is a manufacturing process diagram of a power semiconductor module (500) including a heat dissipation substrate for power semiconductors according to an embodiment.
FIGS 4A to 5B are cross-sectional views of a manufacturing process of a power semiconductor heat dissipation substrate according to an embodiment.
FIG. 6A is an analysis photograph of the first region (P1) of the first heat dissipation substrate (410) illustrated in FIG. 5B.
FIG. 6B is an SEM photograph of a brazing bonding interface according to a conventional AMB technique.
FIGS. 7A to 7C are examples of an etching process, a laser scribing process, and an inspection process for the first heat dissipation substrate (410).
FIG. 8A is an SAT (Scanning Acoustic Tomography) photograph of a heat dissipation substrate according to an embodiment.
FIG. 8B is an SAT photograph of a third heat dissipation substrate using a conventional AMB bonding method.
FIG. 8C is peeling defect data in the SAT image for the fourth heat dissipation substrate of the conventional AMB bonding method.

### DETAILED DESCRIPTION

Hereinafter, the invention according to an embodiment for solving the above problem will be described in more detail with reference to the drawings.

The suffixes "module" and "part" used for components in the following description are given simply for the convenience of writing this specification, and do not themselves give a particularly important meaning or role. Therefore, the "module" and "part" may be used interchangeably.

Terms including ordinal numbers such as first, second, etc. may be used to describe various components, but the components are not limited by the terms. The terms are used only for the purpose of distinguishing one component from another component.

The singular expression includes the plural expression unless the context clearly indicates otherwise.

In the present application, the terms "includes," or "has" are intended to specify the presence of a feature, number, step, operation, component, part, or combination thereof described in the specification, but should be understood as not excluding in advance the possibility of the presence or addition of one or more other features, numbers, steps, operations, components, parts, or combinations thereof.

In an embodiment, the power semiconductor device may be used in an inverter or convertor of an automobile, a computer, a home appliance, a solar power plant, a smart grid, or the like. In an embodiment, the power semiconductor device may include one power semiconductor module or a plurality of power semiconductor modules. In addition, the power semiconductor module may include a plurality of power semiconductor devices.

In the following embodiments, the power semiconductor device describes an automobile inverter for driving a motor, but the power semiconductor device of the embodiment may be applied to an inverter or convertor of various technical fields described above. Here, the automobile includes a hybrid vehicle (HEV), a plug-in hybrid vehicle (PHEV), an electric vehicle (EV), a fuel cell vehicle (PCEV), and the like. In the description of the following embodiments, the switching element and the power semiconductor device may be used interchangeably.

### (Embodiment)

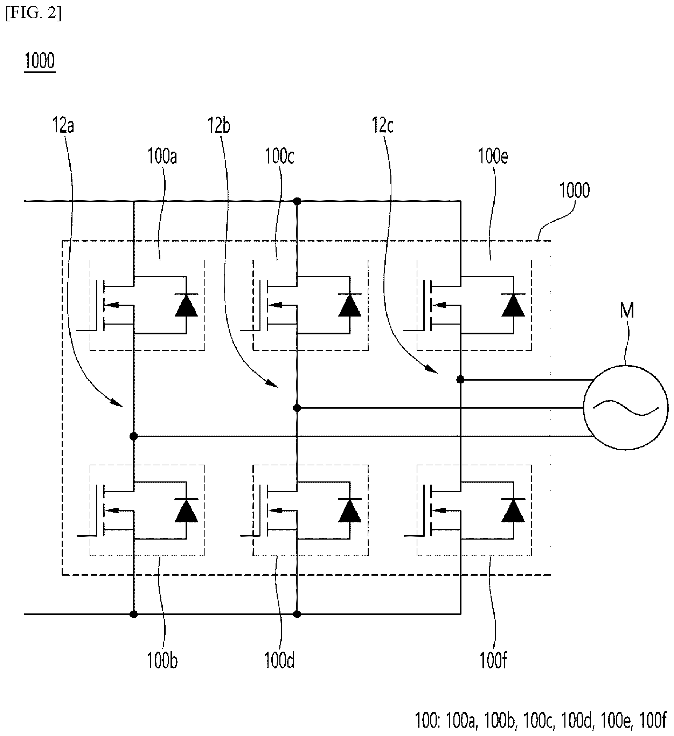

FIG. 2 is a circuit diagram of a power convertor (1000) to which a power semiconductor module according to an embodiment is applied.

The power convertor (1000) according to the embodiment may receive DC power from a battery or a fuel cell, convert it into AC power, and supply AC power to a predetermined load. For example, the power convertor (1000) according to the embodiment may include an inverter, receive DC power from a battery, convert it into three-phase AC power, and supply it to a motor (M), and the motor (M) may provide power to an electric vehicle, a fuel cell vehicle, etc.

The power convertor (1000) according to the embodiment may include a power semiconductor device (100). The power semiconductor device (100) may be a MOSFET (Metal Oxide Semiconductor Field Effect Transistor), but is not limited thereto, and may include an IGBT (Insulated Gate Bipolar Transistor).

For example, the power convertor (1000) may include a plurality of power semiconductor devices (100a, 100b, 100c, 100d, 100e, 100f), and may include a plurality of diodes (not shown). Each of the plurality of diodes may be embedded in the power semiconductor devices (100a, 100b, 100c, 100d, 100e, 100f) in the form of an internal diode, but is not limited thereto, and may be arranged separately.

The embodiment may convert DC power into AC power through on-off control for a plurality of power semiconductor devices (100a to 100f). For example, the power convertor (1000) according to the embodiment may supply positive power to the motor (M) by turning on the first power semiconductor device (100a) and turning off the second power semiconductor device (100b) in a first-time section of one cycle, and supply negative power to the motor (M) by turning off the first power semiconductor device (100a) and turning on the second power semiconductor device (100b) in a second-time section of one cycle.

In the embodiment, a group of power semiconductor devices arranged in series on a high-voltage line and a low-voltage line on the input side may be called an arm. For example, the first and second power semiconductor devices (100a, 100b) may constitute a first arm (12a), the third and fourth power semiconductor devices (100c, 100d) may constitute a second arm (12b), and the fifth and sixth power semiconductor devices (100e, 100f) may constitute a third arm (12c).

The plurality of power semiconductor devices (100a to 100f) illustrated in FIG. 2 may be packaged into one power semiconductor module, or the power semiconductor devices constituting each arm may be packaged into one power semiconductor module.

In the arm, the upper power semiconductor device and the lower power semiconductor device may be controlled not to be turned on at the same time. For example, in the first arm, the first power semiconductor device (100a) and the second power semiconductor device (100b) may not be turned on simultaneously but may be turned on and off alternately.

The power semiconductor device (100) of the embodiment may be a silicon carbide (SiC) power semiconductor device, and may be capable of operating in a high temperature and high voltage environment and may have a high switching speed while having low switching loss.

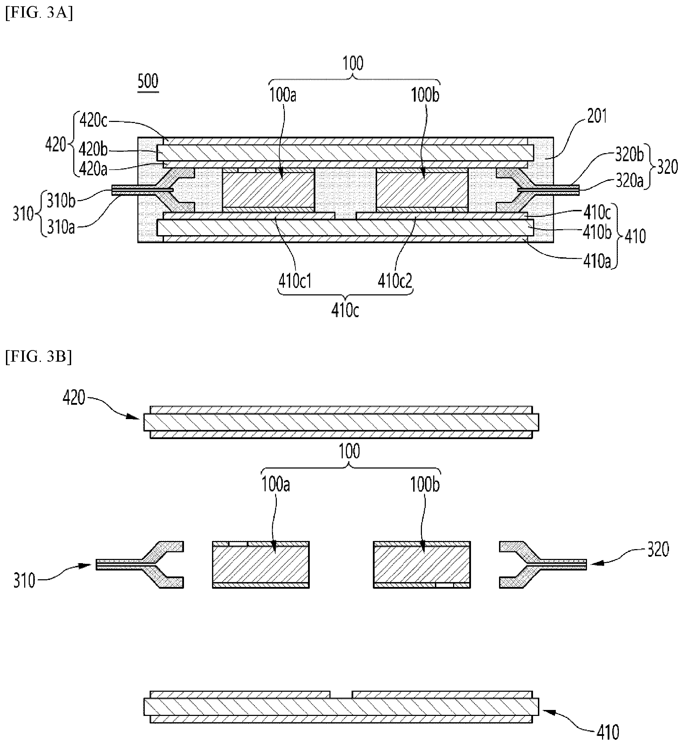

Next, FIG. 3A is a cross-sectional view of a power semiconductor module (500) including a heat dissipation substrate for a power semiconductor according to an embodiment, and FIG. 3B is a manufacturing process drawing of a power semiconductor module (500) including a heat dissipation substrate for a power semiconductor according to an embodiment.

Referring to FIG. 3A, the power semiconductor module (500) according to the embodiment may include a first heat dissipation substrate (410), a second heat dissipation substrate (420), and single or multiple power semiconductor devices (100a, 100b), a first lead frame (310), a second lead frame (320) may be included, and may be packaged by a mold (201). The mold (201) may include EMC (Epoxy Molding Compound), but is not limited thereto.

For example, referring to FIG. 3B, a power semiconductor module (500) according to an embodiment may be manufactured by arranging a first lead frame (310), a second lead frame (320), and a single or multiple power semiconductor devices (100a, 100b) between a first heat dissipation substrate (410), a second heat dissipation substrate (420), and then pressing.

The power semiconductor device (100a, 100b) and the first heat dissipation substrate (410) and the second heat dissipation substrate (420) may be bonded with a predetermined adhesive member (not shown). The adhesive member may be a Sn-Ag series adhesive member or an Ag series adhesive member. Alternatively, the first and second heat dissipation substrates (410) may be bonded to the power semiconductor device (100a, 100b) through soldering or sintering.

Referring again to FIG. 3A, in the power semiconductor module (500) according to the embodiment, the first power semiconductor device (100a) and the second power semiconductor device (100b) may form one arm. For example, as shown in FIG. 3A, the first power semiconductor device (100a) and the second power semiconductor device (100b) may be connected in series with the electrodes arranged in opposite directions, but are not limited thereto. For example, the first power semiconductor device (100a) and the second power semiconductor device (100b) may be electrically connected in parallel.

In the embodiment, the first and second heat dissipation substrates (410, 420) may be arranged on the lower and upper sides of the power semiconductor module (500), respectively.

The first heat dissipation substrate (410) may include a first metal plate (410a), a first ceramic substrate (410b), and a second metal plate (410c).

The first ceramic substrate (410b) may electrically insulate the first metal plate (410a) and the second metal plate (410c). The first ceramic substrate (410b) may include a ceramic material having high thermal conductivity. For example, the first ceramic substrate (410b) may be one of AlN or Si₃N₄, but is not limited thereto.

The first metal plate (410a) may have one side in contact with the first ceramic substrate (410b) and dissipate heat to the other side. A heat dissipation means including a cooling medium may be arranged in close proximity to the other side of the first metal plate (410a).

The second metal plate (410c) may include a wiring pattern formed by a patterning process such as etching, and the wiring pattern may be electrically connected to electrodes of the power semiconductor device (100).

For example, the second metal plate (410c) may include electrically separated second-first wiring patterns (410c1) and second-second wiring patterns (410c2), and may be electrically connected to the first power semiconductor device (100a) and the second power semiconductor device (100b), respectively. The first metal plate (410a) and the second metal plate (410c) may include a Cu-based metal, but are not limited thereto.

In addition, the second heat dissipation substrate (420) may include a third metal plate (420a), a second ceramic substrate (420b), and a fourth metal plate (420c). The second heat dissipation substrate (420) may adopt the technical features of the first heat dissipation substrate (410).

The third metal plate (420a) may include a wiring pattern (not shown), and the wiring pattern may be electrically connected to the power semiconductor device (100). For example, the third metal plate (420a) may be electrically connected to the first power semiconductor device (100a) and the second power semiconductor device (100b).

The fourth metal plate (420c) may have one side in contact with the second ceramic substrate (420b) and the other side may dissipate heat. A heat dissipation means including a cooling medium may be arranged in close proximity to the other side of the fourth metal plate (420c).

Referring to FIG. 3A, each of one side of the first lead frame (310) and the second lead frame (320) may be electrically connected to the power semiconductor device (100), and each of the other sides may be connected to an external connection terminal. The external connection terminal may include an input power supply, a motor, or an inverter controller.

For example, the first lead frame (310) and the second lead frame (320) may be electrically connected to the power semiconductor device (100) through the first heat dissipation substrate (410) and the second heat dissipation substrate (420).

For example, the first lead frame (310) may include a first-first lead frame (310a) electrically connected to the second-first wiring pattern (410c1) of the first heat dissipation substrate (410), and a first-second lead frame (310b) electrically connected to the third metal plate (420a) of the second heat dissipation substrate (420).

In addition, the second lead frame (320) may include a second-first lead frame (320a) electrically connected to the second-second wiring pattern (410c2) of the first heat dissipation substrate (410), and a second-second lead frame (320b) electrically connected to the third metal plate (420a) of the second heat dissipation substrate (420).

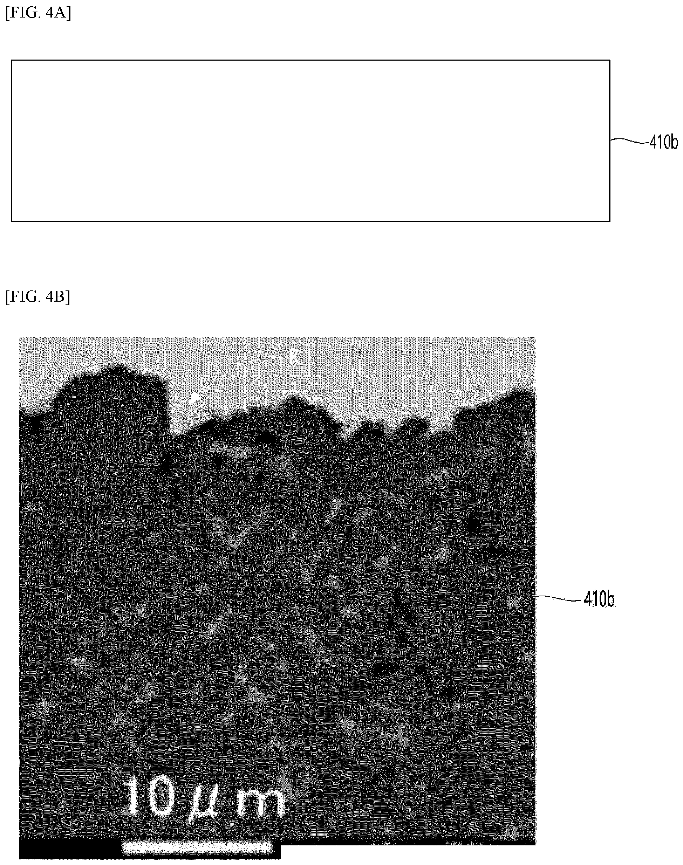

Hereinafter, a manufacturing process of a heat dissipation substrate for power semiconductor modules according to an embodiment will be described with reference to FIGS. 4A to 5B.

First, referring to FIG. 4A, a first ceramic substrate (410b) may be prepared. The first ceramic substrate (410b) may be an oxide-based substrate or a nitride-based substrate. For example, the first ceramic substrate (410b) may be Al₂O₃, AlN, Si₃N₄, or the like, but is not limited thereto.

A CDA (Clean Dried Air) cleaning process and a thickness measurement process may be performed on the first ceramic substrate (410b), but are not limited thereto. The thickness of the first ceramic substrate (410b) may be 200 to 1,000 *µ*m, but are not limited thereto. Preferably, the thickness of the first ceramic substrate (410b) may be 300 to 800 *µ*m, but are not limited thereto.

FIG. 4B is a photograph showing the surface of the first ceramic substrate (410b) in which unevenness (R) is inherent in the internal comparative technique.

There may be unevenness (R) of several *µ*m to several hundred *µ*m in size on the surface of the ceramic substrate. Such unevenness (R) may cause voids to occur in the bonding process when applying the conventional technique.

For example, in the conventional AMB technology, there was a problem of micro voids occurring at the bonding interface due to outgassing of the flux solvent of the paste during brazing heat treatment, or in the conventional DBC technology, due to the difficulty of uniform copper oxide film process.

As described above, in the conventional power semiconductor heat dissipation substrate industry, the occurrence of micro voids smaller than 1 mm in size was considered inevitable because it was difficult to control.

Meanwhile, the applicant's internal comparative technology conducted in-depth research to lower the level of voids at the bonding interface by applying sputtering and hot press bonding technology. However, although the internal comparative technology lowered the level of voids at the bonding interface of the heat dissipation substrate, there was an issue of micro voids due to the anti-oxidation layer and thick bonding metal layer (e.g., Ti layer, etc.) despite the in-depth research.

Referring to FIG. 4B, in the conventional technology or internal comparative technology, the occurrence of micro voids was considered to be more unavoidable due to the irregularities (R) of several *µ*m to several hundred *µ*m in size existing on the surface of the ceramic substrate. However, considering the ultra-high temperature operating temperature environment of the power semiconductor module, a solution is needed to prevent the occurrence of micro voids.

Meanwhile, in the conventional technology, since the copper foil (Cu foil) does not have good bonding strength with the oxide ceramic substrate such as Al₂O₃, in order to manufacture the conventional DBC substrate, a copper oxide film was formed on the copper foil (Cu foil) through a thermal oxidation process, and then heat treatment bonding was performed with the ceramic substrate such as Al₂O₃.

However, in the conventional DBC technology, not only does a separate heat treatment process for the copper foil need to be performed, but also since a uniform copper oxide film is not formed, micro voids exist at the bonding interface, which significantly reduces the reliability of the power semiconductor module.

In the following example, in order to solve the problem of micro voids occurring at the bonding interface of the heat dissipation substrate, a bonding metal layer (411) may be formed on an oxide ceramic substrate (410b), and then a hot press process of the metal plate and the oxide ceramic substrate (410b) may be performed without a separate oxidation process for the metal plate made of Cu.

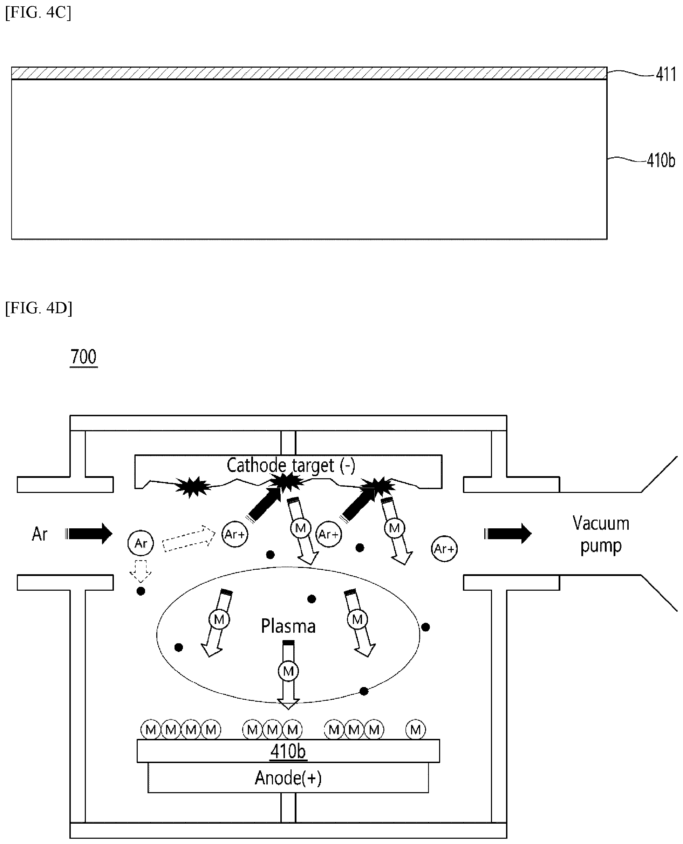

For example, referring to FIG. 4C, a bonding metal layer (411) having a first thickness may be uniformly formed on one surface of a first ceramic substrate (410b) by sputtering.

For example, referring to FIG. 4D, a first ceramic substrate (410b) may be mounted on an anode electrode plate of a predetermined PVD device (700), and a bonding metal layer (411) including Ti or TiW may be formed to a thin first thickness of about 0.05 *µ*m or less in an inert atmosphere such as Ar gas. For example, the bonding metal layer (411) may be formed to a thickness of about 0.01 to 0.03 *µ*m, but is not limited thereto.

Next, referring to FIG. 4E, the first ceramic substrate (410b) on which the bonding metal layer (411) is formed on one surface may be turned over, and another bonding metal layer (411) may be formed on the opposite surface by sputtering, thereby manufacturing the first ceramic substrate (410b).

Next, referring to FIG. 5A, the first metal plate (410a) and the second metal plate (410c) are respectively disposed on the lower and upper sides of each of the plurality of first ceramic substrates (410b), and a hot press process may be performed in a vacuum state, thereby manufacturing each the first heat dissipation substrate (410) as shown in FIG. 5B.

The first and second metal plates (410a, 410c) may include copper or copper alloy material, but it is not limited thereto. In addition, the first and second metal plates (410a, 410c) may have a thickness of about 200 µm to 400 µm, but is not limited thereto.

At this time, the hot press process may be performed by interposing a plurality of spacers (415). For example, the spacer (415) may be a carbon spacer, a ceramic spacer, etc., but is not limited thereto.

The temperature of the hot press process may be about 900°C to 1,100°C. Preferably, the temperature of the hot press process may be about 950°C to 1,080°C, but is not limited thereto.

The vacuum level of the hot press process may be a vacuum level of 1.0x10⁻¹ torr or more, but is not limited thereto. In addition, the pressure of the hot press process may be about 100 MPa or less, but is not limited thereto. For example, the pressure of the hot press process may be about 1 MPa to about 20 MPa, but is not limited thereto.

Next, FIG. 6A is an analysis photograph of the first region (P1) of the first heat dissipation substrate (410) illustrated in FIG. 5B.

Referring to FIG. 6A, there is a special technical effect in which no micro voids exist at the bonding interface between the oxide ceramic substrate (410b) and the Cu metal plate (410c) of the first heat dissipation substrate (410) according to the embodiment.

According to the embodiment, there is a special technical effect in which high-temperature reliability can be enhanced and high-temperature bonding strength can be improved by implementing micro void free in a power semiconductor module operating at an ultra-high temperature of 300°C or higher.

In addition, according to the embodiment, cracks occurring at the bonding interface between the ceramic substrate of the heat dissipation substrate and the copper sheet can be prevented from occurring, thereby improving the reliability of the power semiconductor device.

Specifically, referring to FIG. 6A, the first heat dissipation substrate (410) may include an oxide bonding layer (412) between the first ceramic substrate (410b) and the second metal plate (410c).

For example, referring to FIG. 5B and FIG. 6A together, in the embodiment, after forming a bonding metal layer (411) on the oxide ceramic substrate (410b), a high temperature and high pressure hot press process of the metal plate and the oxide ceramic substrate (410b) may be performed without a separate oxidation process for the Cu material metal plates (410a, 410c).

According to an embodiment, in a state without a separate oxidation process, the bonding metal layer (411) may react with the oxide ceramic substrate (410b) to form the oxide bonding layer (412) by a hot press process of the metal plate and the oxide ceramic substrate (410b). And this oxide bonding layer (412) may obtain a strong bonding force between the Cu material metal plate (410a, 410c) and the oxide ceramic substrate (410b). Also, the oxide bonding layer (412) can be uniformly and thinly formed as a separate oxidation process is not performed such that there is a special technical effect in which no micro voids exist at the bonding interface between the oxide ceramic substrate (410b) and the Cu material metal plate (410c).

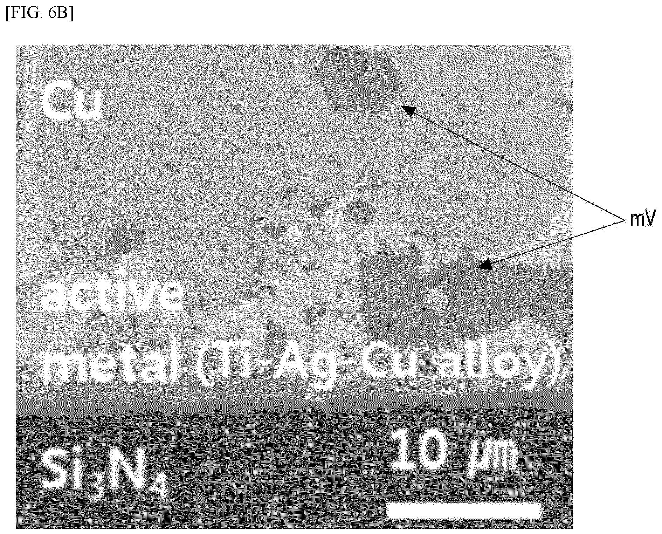

Meanwhile, FIG. 6B is an SEM photograph of a brazing bonding interface according to a conventional AMB technology.

When applying conventional AMB technology, an intermediate material exists between the Si₃N₄ ceramic substrate and the Cu sheet in the form of a Ti-Ag-Cu alloy, and micro voids (mV) of several *µ*m to several tens *µ*m in size exist at the bonding interface with a thickness of about 15 *µ*m.

On the other hand, according to the embodiment, there is a special technical effect of enhancing high-temperature reliability and improving high-temperature bonding strength by implementing micro void free in a power semiconductor module operating at an ultra-high temperature of 350°C or higher.

In addition, according to the embodiment, there is a technical effect of preventing cracks occurring at the bonding interface between the ceramic substrate of the heat dissipation substrate and the copper sheet, thereby improving the reliability of the power semiconductor device.

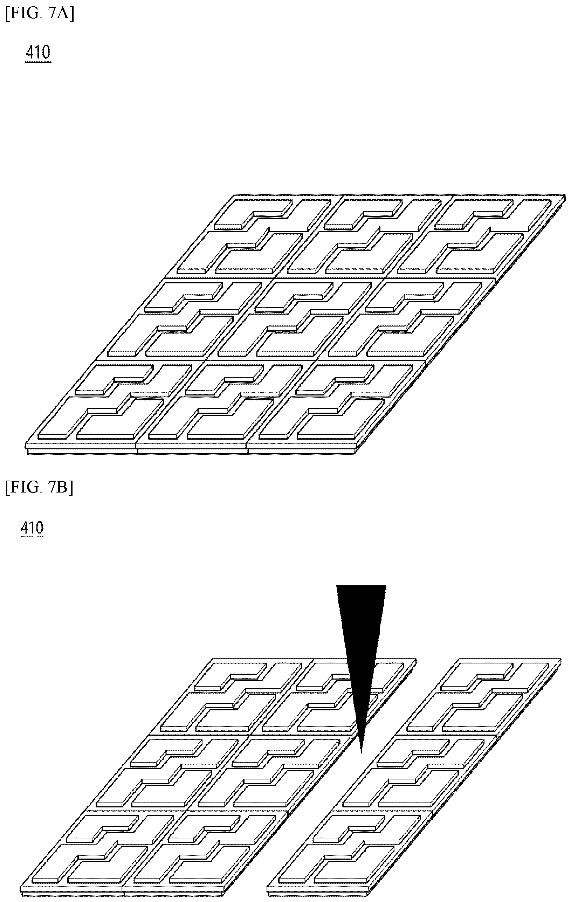

Next, FIGS. 7A to 7C are examples of an etching process, a laser scribing process, and an inspection process for the first heat dissipation substrate (410).

Referring to FIG. 7A, a wiring pattern may be formed through an etching process on the first heat dissipation substrate (410) on which the hot press process has been performed. For example, a wiring pattern may be formed by partially removing the second metal plate (410c) of the first heat dissipation substrate (410). At this time, the bonding metal layer (411) and the bonding layer (413) may also be removed.

Next, referring to FIG. 7B, a laser scribing process and a breaking process may be performed.

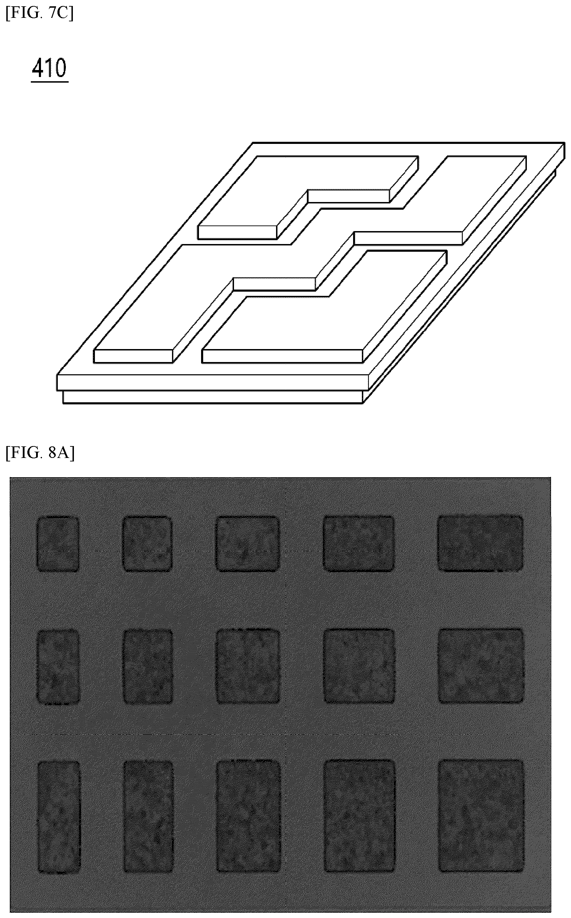

Afterwards, referring to FIG. 7C, an inspection process may be performed. The inspection process may include an ultrasonic inspection (SAT) that inspects voids or cracks in the bonding interface using ultrasonic waves.

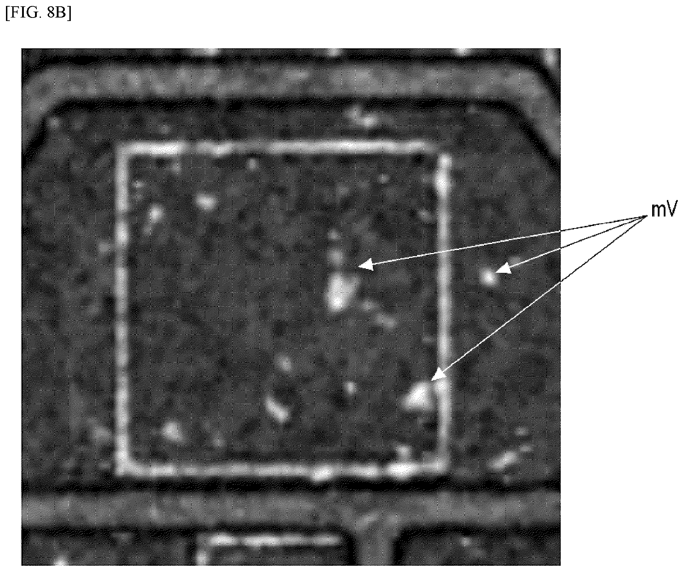

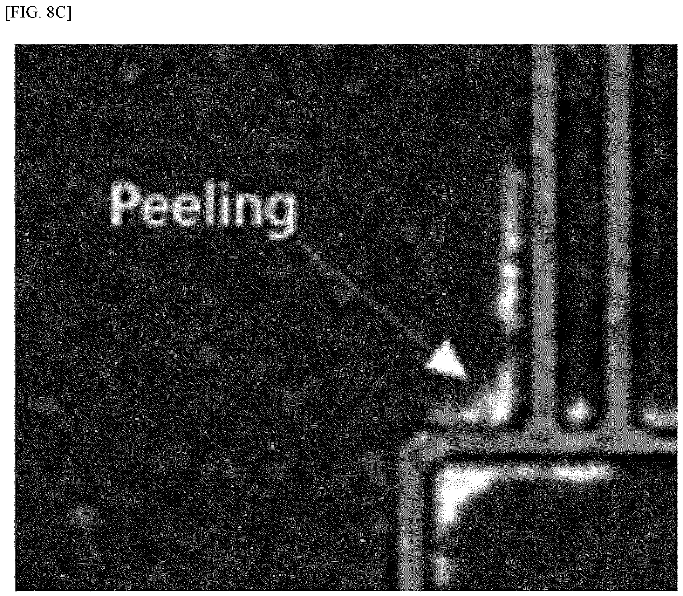

Next, FIG. 8Ais an SAT photograph of a heat dissipation substrate according to an embodiment.

On the other hand, FIG. 8B is a SAT image of a third heat dissipation substrate using a conventional AMB bonding method.

Referring to FIG. 8B, the conventional AMB technology has a problem in that outgassing occurs when the flux solvent included in the paste is vaporized during heat treatment, and micro voids (mV) occur at the bonding interface as the gas t may not completely escape.

In the case of the conventional AMB technology, there is a problem in that the heat dissipation characteristics may be deteriorated due to the micro voids that occur at the bonding interface of the heat dissipation substrate, also the bonding strength may be deteriorated.

On the other hand, referring to FIG. 8A, according to an embodiment, after forming a bonding metal layer (411) on an oxide ceramic substrate (410b), a high temperature and high pressure hot press process may be performed on the metal plate (410a, 410c) made of Cu without a separate oxidation process.

According to an embodiment, the bonding metal layer (411) may react with the oxide ceramic substrate (410b) to form an oxide bonding layer (412) through a hot press process of the metal plate (410a, 410c) and the oxide ceramic substrate (410b) without a separate oxidation process, and this oxide bonding layer (412) can obtain a strong bonding force between the Cu metal plate (410a, 410c) and the oxide ceramic substrate (410b).

Accordingly, according to the embodiment, since a separate oxidation process is not performed on the metal plates (410a, 410c) before bonding, the uniformly formed bonding metal layer (411) may change into an oxide bonding layer (412). And in a power semiconductor module operating at an ultra-high temperature of 350°C or higher, a micro void free can be implemented at the bonding interface between the oxide ceramic substrate (410b) and the Cu material metal plate (410c), and there is special technical effect of enhancing high-temperature reliability and improving high-temperature bonding strength.

Next, FIG. 8C is a peeling defect data in a SAT image for the fourth heat dissipation substrate of the conventional AMB bonding method.

In the case of the heat dissipation substrate of the conventional AMB bonding method, there is a problem of peeling occurring when conducting a thermal shock reliability test.

In addition, in the case of the conventional AMB bonding method, a warpage may occur due to the difference in thermal expansion coefficient between the ceramic substrate and the metal material of the metal plate in a repetitive temperature change environment, and furthermore, in a high-vibration, high-impact operating environment, there is a problem that micro voids cause cracks when the substrate warps.

On the other hand, according to the embodiment, by preventing the occurrence of micro voids at the bonding interface between the ceramic substrate and the copper sheet of the heat dissipation substrate, there is a technical effect that cracks do not occur even if warpage occurs due to the difference in thermal expansion coefficient.

Although the present invention has been described above with reference to the embodiments, it will be easily understood by those skilled in the art that various modifications and changes may be made to the present invention without departing from the scope of the present invention described in the following claims.

## Claims

1. A method for manufacturing a heat dissipation substrate for a power semiconductor module, comprising:
preparing an oxide-based substrate (410b);
forming a bonding metal layer (411) on at least one side of the substrate (410b) by sputtering;
arranging a metal plate (410a, 410c) on the bonding metal layer (411); and
performing a hot press process such that the bonding metal layer (411) is converted into an oxide bonding layer (412).

2. The method according to claim 1, wherein the substrate (410b) comprises an oxide-based ceramic substrate.

3. The method according to any one of the preceding claims, wherein after the hot press process, the oxide bonding layer (412) is disposed between the substrate (410b) and the metal plate (410a, 410c).

4. The method according to any one of the preceding claims, wherein the bonding metal layer (411) comprises Ti or TiW.

5. The method according to any one of the preceding claims, wherein the bonding metal layer (411) is formed with a thickness of 0.01 to 0.03 *µ*m.

6. The method according to any one of the preceding claims, wherein the oxide bonding layer (412) comprises titanium oxide.

7. The method according to any one of the preceding claims, wherein the hot press process is performed at a temperature above 500°C and/or at a pressure of more than 0,5MPa and less than 100 MPa.

8. A heat dissipation substrate for a power semiconductor module, comprising:
a first metal plate (410a);
an oxide-based substrate (410b) bonded on the first metal plate (410a);
a second metal plate (410c) bonded on the substrate (410b); and
an oxide bonding layer (412) between the substrate (410b) and the first metal plate (410a) and/or between the substrate (410b) and the second metal plate (410c),
wherein the oxide bonding layer (412) is formed by a hot press process.

9. The heat dissipation substrate according to claim 8, wherein the substrate (410b) comprises an oxide-based ceramic substrate.

10. The heat dissipation substrate according to claim 8 or 9, wherein the oxide bonding layer (412) comprises titanium oxide.

11. The heat dissipation substrate according to claim 8, 9 or 10, wherein a thickness of the oxide bonding layer (412) is 0.01 to 0.03 *µ*m.

12. The heat dissipation substrate according to any one of claims 8 to 11, wherein the first and/or second metal plate includes copper.

13. A power semiconductor module, comprising;
at least one heat dissipation substrate according to any one of claims 8 to 12;
at least one lead frame (310, 320); and
at least one power semiconductor device (100a, 100b).

14. A power convertor comprising the power semiconductor module according to claim 13.

## Amended claims

### Amended claims in accordance with Rule 137(2) EPC.

1. A method for manufacturing a heat dissipation substrate for a power semiconductor module, comprising:
preparing an oxide-based substrate (410b);
forming a bonding metal layer (411) on at least one side of the substrate (410b) by sputtering;
arranging a metal plate (410a, 410c) on the bonding metal layer (411); and
performing a hot press process such that the bonding metal layer (411) is converted into an oxide bonding layer (412),
wherein the oxide bonding layer (412) is arranged at an interface between the oxide-based substrate (410b) and the metal plate (410a, 410c).

2. The method according to claim 1, wherein the substrate (410b) comprises an oxide-based ceramic substrate.

3. The method according to any one of the preceding claims, wherein the bonding metal layer (411) comprises Ti or TiW.

4. The method according to any one of the preceding claims, wherein the bonding metal layer (411) is formed with a thickness of 0.01 to 0.03 *µ*m.

5. The method according to any one of the preceding claims, wherein the oxide bonding layer (412) comprises titanium oxide.

6. The method according to any one of the preceding claims, wherein the hot press process is performed at a temperature above 500°C and/or at a pressure of more than 0,5MPa and less than 100 MPa.

7. A heat dissipation substrate for a power semiconductor module, comprising:
a first metal plate (410a);
an oxide-based substrate (410b) bonded on the first metal plate (410a);
a second metal plate (410c) bonded on the substrate (410b); and
an oxide bonding layer (412) between the substrate (410b) and the first metal plate (410a) and/or between the substrate (410b) and the second metal plate (410c),
wherein the oxide bonding layer (412) is formed by a hot press process,
wherein the oxide bonding layer (412) is arranged at an interface between the oxide-based substrate (410b) and the metal plate (410a, 410c).

8. The heat dissipation substrate according to claim 7, wherein the substrate (410b) comprises an oxide-based ceramic substrate.

9. The heat dissipation substrate according to claim 7 or 8, wherein the oxide bonding layer (412) comprises titanium oxide.

10. The heat dissipation substrate according to claim 7, 8 or 9, wherein a thickness of the oxide bonding layer (412) is 0.01 to 0.03 *µ*m.

11. The heat dissipation substrate according to any one of claims 7 to 10, wherein the first and/or second metal plate includes copper.

12. A power semiconductor module, comprising;
at least one heat dissipation substrate according to any one of claims 7 to 11;
at least one lead frame (310, 320); and
at least one power semiconductor device (100a, 100b).

13. A power convertor comprising the power semiconductor module according to claim 12.
